Europäisches Patentamt

European Patent Office

Office européen des brevets

(19)

(11) Veröffentlichungsnummer: **0 434 941 A1**

# EUROPÄISCHE PATENTANMELDUNG

(12)

(21) Anmeldenummer: 90121185.4

(22) Anmeldetag: 06.11.90

(51) Int. Cl.5: **H03J 7/08**, H03B 5/12

(30) Priorität: 01.12.89 DE 3939742

(43) Veröffentlichungstag der Anmeldung:
03.07.91 Patentblatt 91/27

(84) Benannte Vertragsstaaten:
**AT CH DE ES FR GB IT LI**

(71) Anmelder: **TELEFUNKEN electronic GmbH**
**Theresienstrasse 2**
**W-7100 Heilbronn(DE)**

(72) Erfinder: **Küspert, Ludwig**
**Austrasse 7**
**W-8079 Hofstetten(DE)**
Erfinder: **Schultz, Georg**
**Schiessstättweg 17**
**W-8069 Geisenfeld(DE)**

(74) Vertreter: **Maute, Hans-Jürgen, Dipl.-Ing.**
**TELEFUNKEN electronic GmbH**
**Theresienstrasse 2**
**W-7100 Heilbronn(DE)**

(54) Schaltungsanordnung zur Zuführung eines AFC-Signales.

(57) Eine Schaltungsanordnung zur Zuführung eines AFC-Signales, bestehend aus einem ersten Oszillator (1) für einen hochfrequenten Frequenzbereich und einem zweiten Oszillator (2) für einen niederfrequenten Frequenzbereich, wobei der erste und zweite Oszillator jeweils mit einem die Frequenz des jeweiligen Oszillators bestimmenden Parallelschwingkreis (3,4) gekoppelt ist, dem außerdem eine Abstimmspannung ($U_A$) zugeführt ist. Erfindungsgemäß ist eine Reaktanzstufe (5) zur Zuführung des AFC-Signales vorgesehen, wobei diese Reaktanzstufe einerseits über eine Koppelspule (L31) mit dem Parallelschwingkreis (3) des ersten Oszillators und andererseits über einen Koppelkondensator ($C_{31}$) mit dem Parallelschwingkreis (4) des zweiten Oszillators verbunden ist sowie eine abstimmbare Kapazitätsdiode ($D_{31}$) umfaßt. Hierdurch ergibt sich eine AFC-Beschaltung ohne kapazitive Belastung des höherfrequenten Oszillatorschwingkreises, wodurch ein maximaler Abstimmbereich erzielbar ist.

FIG. 2

EP 0 434 941 A1

## SCHALTUNGSANORDNUNG ZUR ZUFÜHRUNG EINES AFC-SIGNALES

Die Erfindung betrifft eine Schaltungsanordnung zur Zuführung eines AFC-Signales mit einem ersten Oszillator für einen hochfrequenten Frequenzbereich und einem zweiten Oszillator für einen niederfrequenten Frequenzbereich gemäß dem Oberbegriff des Anspruches 1.

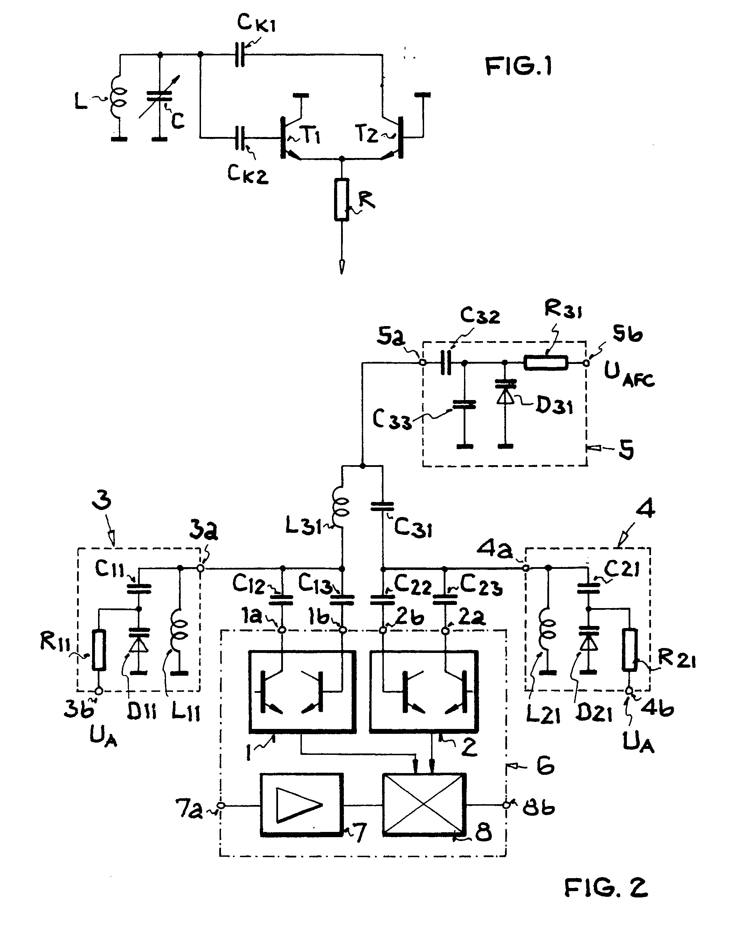

Die Erfindung geht aus von einem Schaltkreis mit zwei Oszillatoren, wie sie beispielsweise in einer VHF-Mischstufe für die Fernsehbänder I, III und für das erweiterte Band III verwendet werden, wobei diese beiden Oszillatoren jeweils für ein bestimmtes Frequenzband vorgesehen sind. Solche Oszillatoren können beispielsweise als emittergekoppelte LC-Oszillatoren mittels eines Differenzverstärkers gemäß der Figur 1 aufgebaut sein, wonach die Mitkopplung über eine Reihenschaltung zweier Koppelkondensatoren $C_{K1}$ und $C_{K2}$ erfolgt, die die Basis-Elektrode eines Transistors T1 mit der Kollektor-Elektrode eines Transistors T2 verbindet, wobei der Verbindungspunkt dieser beiden Kondensatoren an einem aus einer Spule L und einem einstellbaren Kondensator C bestehenden Parallelschwingkreis angeschlossen ist, wodurch sich mit diesem Kondensator C die Oszillatorfrequenz einstellen läßt.

Das Prinzip der automatischen Frequenzabstimmung (AFC) eines Oszillators in einer Mischstufe ist seit langem aus der Schaltungstechnik von Rundfunkempfängern be kannt, wonach die Frequenz des Oszillators so geregelt wird, daß die richtige Zwischenfrequenz gebildet wird.

Der Erfindung liegt die Aufgabe zugrunde, eine Schaltungsanordnung zur Zuführung eines AFC-Signales mit einem ersten Oszillator für einen hochfrequenten Frequenzbereich und einem zweiten Oszillator für einen niederfrequenten Frequenzbereich gemäß dem Oberbegriff des Anspruchs 1 anzugeben, die einfach und damit auch kostengünstig herstellbar ist.

Die Lösung dieser Aufgabe ist bei einer gattungsgemäßen Schaltungsanordnung durch die kennzeichnenden Merkmale des Anspruches 1 gegeben.

Die erfindungsgemäße AFC-Beschaltung erfordert nur wenige Bauelemente und bewirkt keine kapazitive Belastung des höherfrequenten Schwingkreises, wodurch der Abstimmbereich von diesem nicht eingeschränkt wird.

Weitere vorteilhafte Ausgestaltungen der erfindungsgemäßen Schaltungsanordnung sind den Ansprüchen 2 bis 6 entnehmbar.

Im folgenden soll ein Ausführungsbeispiel in Verbindung mit den Zeichnungen dargestellt und erläutert werden. Es zeigen:

Figur 2
ein Schaltbild eines Ausführungsbeispieles der erfindungsgemäßen Schaltungansordnung,
Figuren 3a bis 3e
Ersatzschaltbilder des Schaltbildes des Ausführungsbeispieles gemäß der Figur 2 bei Betrieb des zweiten Oszillators, und
Figuren 4a bis 4c
Ersatzschaltbilder des Schaltbildes des Ausführungsbeispieles gemäß der Figur 2 bei Betrieb des ersten Oszillators.

In Figur 2 ist mit den Bezugzeichen 6 eine Mischstufe bezeichnet, die einen ersten Oszillator 1 , einen zweiten Oszillator 2 sowie eine Verstärkerstufe 7 und einen Mischer 8 enthält. Diese beiden Oszillatoren 1 und 2 sind jeweils aus zwei Transistoren gemäß der Schaltung nach Figur 1 aufgebaut, wobei jeweils eine erste Anschlußklemme 1a bzw. 2a mit der Kollektor-Elektrode des einen Transistors und eine zweite Anschlußklemme 1b bzw. 2b mit der Basis-Elektrode des anderen Transistors verbunden ist. Die Verstärkerstufe 7 erhält über eine Eingangsklemme 7a die HF-Signale, die verstärkt dem Mischer 8 zugeführt werden, der mittels der ihm ebenfalls zugeführten Oszillatorfrequenzen die Zwischenfrequenzen erzeugt, die an einer Ausgangklemme 8b zur Verfügung stehen.

Ein erster Parallelschwingkreis 3 ist mit seinem ersten Anschlußkontakt 3a sowohl über einen Kondensator C12 mit dem ersten Anschlußkontakt 1a des ersten Oszillators 1 als auch über einen weiteren Kondensator C13 mit dessen zweiten Anschlußkontakt 1b verbunden. Der Parallelschwingkreis 3 ist aus einer Spule L11 sowie aus einer Reihenschaltung aus einer abstimmbaren Kapazitätsdiode D11 und einem Kondensator C11 aufgebaut, wobei der Hochpunkt der Spule L11 an den ersten Anschlußkontakt 3a angeschlossen ist und deren Fußpunkt auf dem Bezugspotential der Schaltung liegt. Die Kathode der Kapazitätsdiode D11 ist sowohl über einen Widerstand R11 mit einem zweiten Anschlußkontakt 3b zur Zuführung einer Abstimmspannung $U_A$ als auch über den Kondensator C11 mit dem Hochpunkt der Spule L11 verbunden, während deren Anode ebenfalls auf dem Bezugspotential der Schaltung liegt. Schließlich ist der erste Anschlußkontakt 3a des ersten Parallelschwingkreises 3 über eine Koppelspule L31 mit einem ersten Anschlußkontakt 5a einer Reaktanzstufe 5 verbunden. Ferner ist dieser erste Anschlußkontakt 5a über einen Koppelkondensator C31 mit einem ersten Anschlußkontakt 4a eines zweiten Parallelschwingkreises 4 verbunden, der seinerseits sowohl über einen Kondensator C23 mit dem ersten Anschlußkontakt 2a des zweiten Oszillators 2 als auch über einen weiteren Kondensator C22 mit dessen zweiten Anschlußkontakt 2b verbunden.

Dieser Parallelschwingkreis 4 umfaßt ebenfalls eine Spule L21 und eine aus einem Kondensator C21 und einer Kapazitätsdiode D21 aufgebauten Parallelschwingkreis, wobei diese Bauelemente entsprechend des ersten Parallelschwingkreises 3 verschaltet sind. Zusätzlich wird dem Verbindungspunkt von der Kapazitätsdiode D21 mit dem Kondensator C21 über einen Widerstand R21, der mit einem zweiten Anschlußkontakt 4b dieses Parallelschwingkreises 4 verbunden ist, die Abstimmspannung $U_A$ zugeführt.

Die Reaktanzstufe 5 umfaßt zwei Kondensatoren C32 und C33, eine abstimmbare Kapazitätsdiode D31 sowie einen Widerstand R31 , wobei der an den ersten Anschlußkontakt 5a der Reaktanzstufe 5 angeschlossene, als Gleichspannungssperre wirkende Kondensator C32 sowohl über den weiteren Kondensator C33 und der Kapazitätsdiode D31 mit dem Bezugspotential der Schaltung verbunden ist als auch über den Widerstand R31 an einen zweiten Anschluß kontakt 5b der Reaktanzstufe 5 angeschlossen ist, dem das AFC-Signal $U_{AFC}$ zugeführt wird.

Wie aus der eben beschriebenen Schaltungsanordnung ersichtlich ist, besteht derjenige Schaltungsteil zur Zuführung des AFC-Signales $U_{AFC}$ nur aus der Reaktanzstufe 5 und den beiden Koppelelementen L31 und C31, umfaßt also nur 6 Bauelemente, wobei in vorteilhafter Weise dieser Schaltungsteil zur Zuführung des AFC-Signales sowohl bei Betrieb des ersten Oszillator 1 als auch bei Betrieb des zweiten Oszillators 2 dient.

Nachfolgend soll die Funktion der Schaltungsanordnung gemäß der Figur 2 erläutert werden. Hierzu soll zuerst der Fall betrachtet werden, wo der zweite, dem niederfrequenten Frequenzbereich zugeordnete Oszillator 2 in Betrieb ist und erst anschließend derjenige, der den ersten, in Betrieb befindlichen Oszillator 1 betrifft, wobei dieser erste Oszillator für den hochfrequenten Frequenzbereich vorgesehen ist.

Zwecks Vereinfachung sind die Verstärkerstufe 7 und der Mischer 8 der Mischstufen 6 in den nachfolgend beschriebenen Figuren nicht dargestellt.

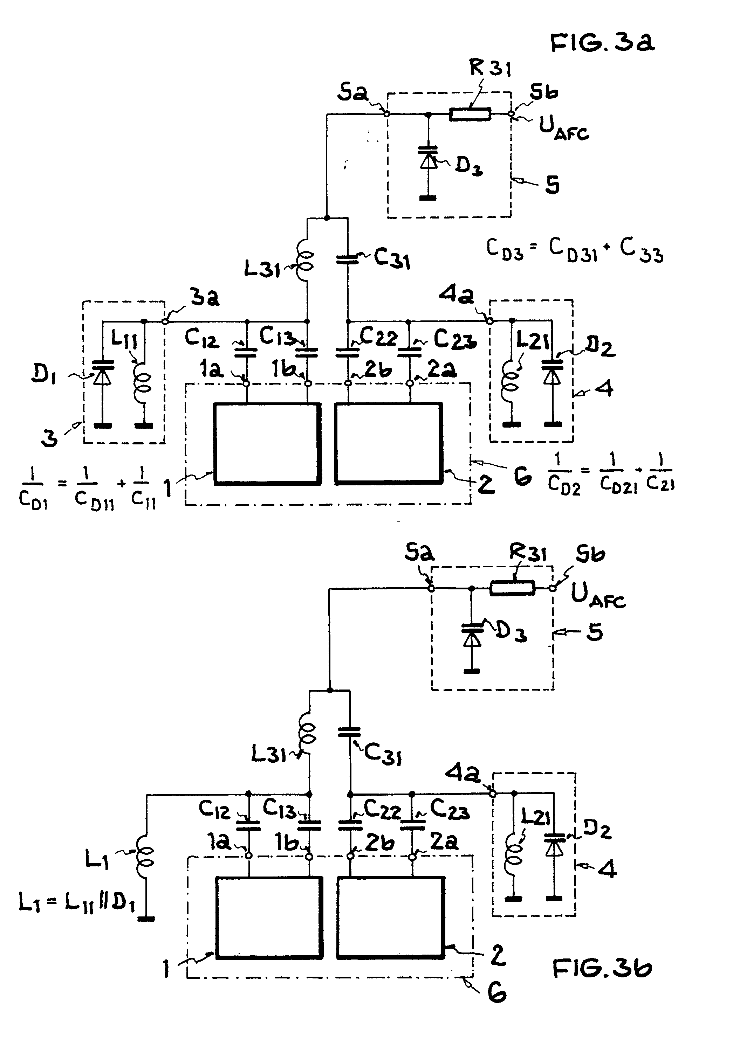

Die Figur 3a zeigt ein erstes Ersatzschaltbild des Schaltbildes gemäß Figur 2, wonach die aus dem Kondensator C11 und der Abstimmdiode D11 bzw. dem Kondensator C21 und der Abstimmdiode D21 bestehende Reihenschaltung des ersten bzw. zweiten Parallelschwingkreises 3 bzw. 4 durch eine Abstimmdiode D1 bzw. D2 ersetzt ist. Der reziproke Wert der Kapazität $C_{D1}$ bzw. $C_{D2}$ dieser Ersatzabstimmdiode D1 bzw. D2 ergibt sich aus den der Figur 2 beigefügten Formeln. Ferner werden auch die Abstimmdiode D31 sowie der weitere Kondensator C33 der Reaktanzstufe 5 zu einer Abstimmdiode D3 zusammengefaßt. Aus der beistehenden Formel für den reziproken Wert der Kapazität $C_{D3}$ dieser Ersatzabstimmdiode D3 läßt sich deren Kapazität ebenfalls berechnen.

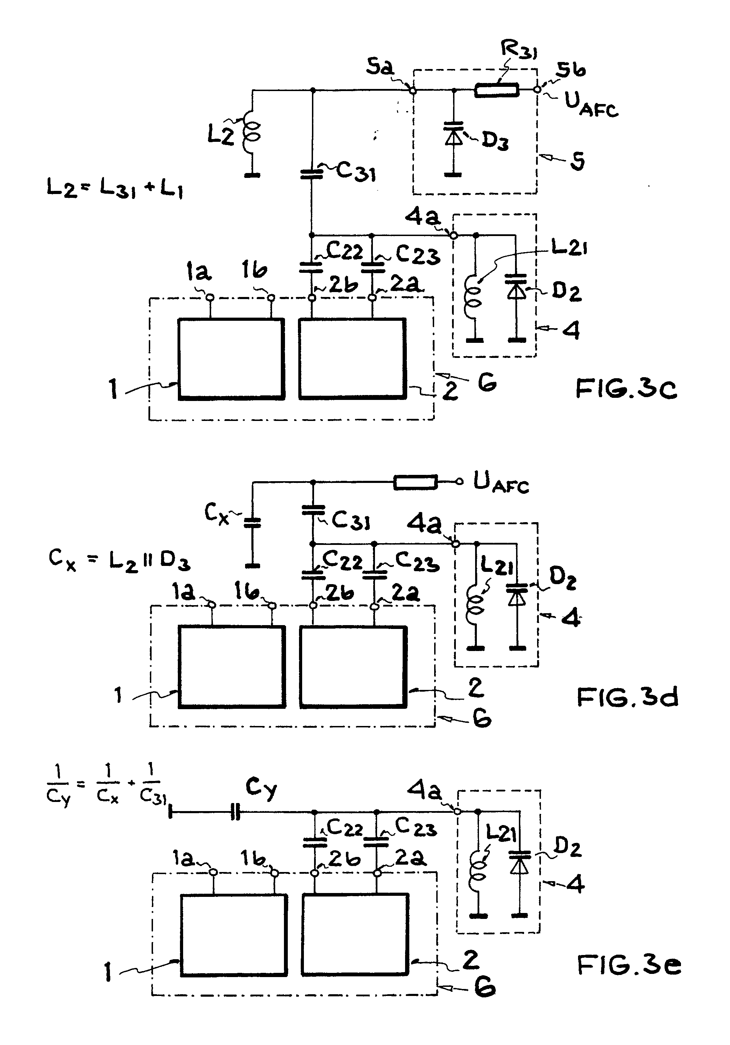

Da die Resonanzfrequenz des zweiten Oszillators 4 unter derjenigen des ersten Oszillators 3 liegt, wird der aus der Kapazitätsdiode D1 und der Spule L11 bestehende Parallelschwingkreis des ersten Oszillators 3 induktiv, so daß diese beiden Elemente durch eine Spule L1 ersetzt werden können, wie es die Figur 3b zeigt. Nun kann in einem weiteren Schritt die Ersatzinduktivität L1 und die Koppelspule L31 zu einer Ersatzinduktivität L2 gemäß Figur 3c ersetzt werden. Die Ersatzinduktivität L2 und die Abstimmdiode D3 stellen einen Parallelschwingkreis dar, der mit einer oberhalb dessen Resonanzfrequenz liegenden Frequenz gespeist wird. Daher wirkt dieser Parallelschwingkreis kapazitiv, womit er durch eine Ersatzkapazität $C_x$ darstellbar ist, wie es die Figur 3d zeigt. Die Reihenschaltung von C31 und $C_x$ ergibt den in Figur 3e dargestellten Ersatzkondensator $C_y$. Dieses letzte Ersatzschaltbild gemäß der Figur 3e zeigt nun, daß eine kleine Kapazitätsänderung an der Kapazitätsdiode D31 der Reaktanzstufe 5 eine entsprechende Kapazitätsänderung der Ersatzkapazität $C_y$ bewirkt.

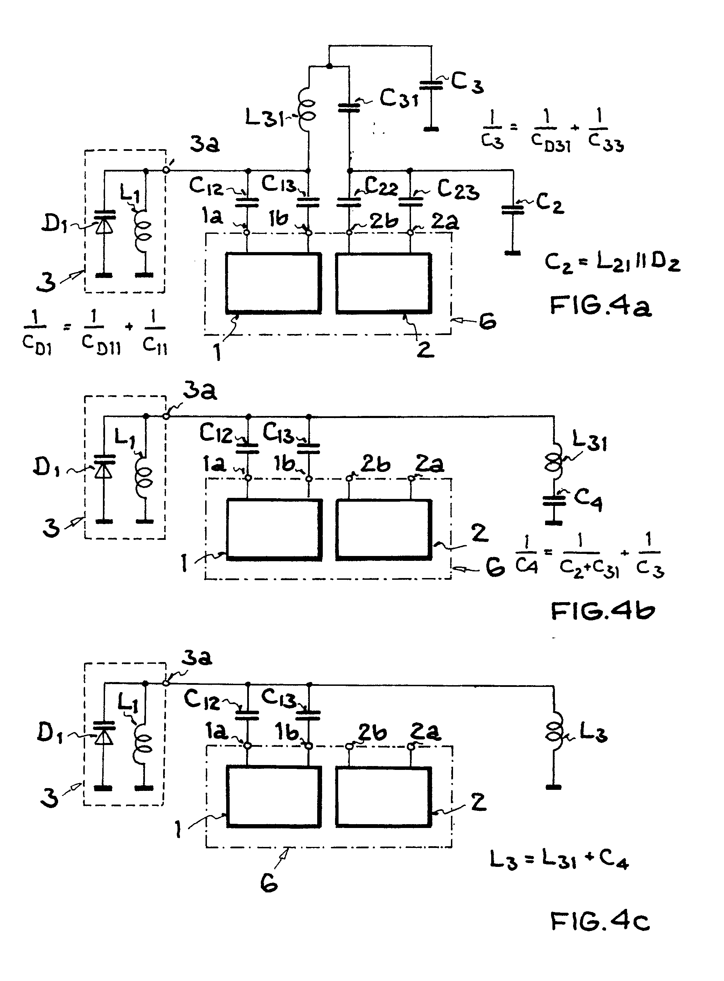

Für den höherfrequenten Betrieb mittels des Oszillators 1 ergibt sich folgende Ableitung der Ersatzschaltbilder gemäß den Figuren 4a bis 4c, wonach im ersten Schritt die Reihenschaltung aus der Kapazitätsdiode D11 und dem Kondensator C11 des ersten Parallelschwingkreises 3 durch eine Abstimmdiode D1 mit einer Kapazität $C_{D1}$ er setzt werden. Dies wird ebenso für den Kondensator C21 und der Kapazitätsdiode D21 für den zweiten Parallelschwingkreis 4 mit einer Abstimmdiode D2 durchgeführt.

Da nun dieser zweite Parallelschwingkreis 4 mit einer über dessen Resonanzfrequenz liegenden Frequenz gespeist wird, stellt derselbe ein kapazitives Element dar, womit er mittels einer Ersatzkapazität C2 gemäß Figur 4a dargestellt ist. Schließlich werden auch die zwei Kapazitäten C33 und D31 der Reaktanzstufe 5 zu einer Ersatzkapazität C3 zusammengefaßt. Die Figur 4b zeigt nun das nächste Ersatzschaltbild, wonach die beiden Ersatzkapazitäten C3 und C2 sowie die Koppelkapazität C31 zu einer Ersatzkapazität C4 zusammengefaßt werden, deren reziproker Kapazitätswert aus der beistehenden Formel ergibt. Hierdurch ergibt sich ein aus der Ersatzkapazität C4 und der Koppelspule L31 aufgebauter Reihenschwingkreis, der ebenfalls mit einer über seiner Resonanzfrequenz liegenden Frequenz gespeist wird, wodurch er als Induktivität aufgefaßt werden kann. Diese Induktivität ist gemäß der Figur 4c mit dem Bezugszeichen L3 versehen. Somit ergibt sich in diesem Betriebsfall, daß eine Änderung der Kapazität der Abstimmdiode D31 eine Induktivitätsänderung der Ersatzinduktivität L3 verursacht.

Zusammenfassend ist daher festzustellen, daß im höherfrequenten Betrieb eine Änderung der Kapazität der Abstimmdiode D31 der Reaktanzstufe 5 zu kleineren Werten hin eine Induktivitätsänderung der Ersatzinduktivität L3 zu kleineren Werten hin verursacht und umgekehrt im niederfrequenten Betrieb verursacht eine Kapazitätsänderung der Abstimmdiode D31 der Reaktanzstufe 5 eine Kapazitätsänderung der Ersatzkapazität $C_y$.

**Ansprüche**

1. Schaltungsanordnung zur Zuführung eines AFC-Signales, bestehend aus einem ersten Oszillator (1) für einen hochfrequenten Frequenzbereich, insbesondere von 146 MHz bis 336 MHz, und einem zweiten Oszillator (2) für einen niederfrequenten Frequenzbereich, insbesondere von 86 MHz bis 146 MHz, wobei mit dem ersten und zweiten Oszillator (1, 2) jeweils ein die Resonanzfrequenz des jeweiligen Oszillators (1 , 2) bestimmender Parallelschwingkreis (3, 4) gekoppelt ist, dem außerdem eine Abstimmspannung ($U_A$) zugeführt wird, dadurch gekennzeichnet, daß eine Reaktanzstufe (5) zur Zuführung des AFC-Signales vorgesehen ist, daß diese Reaktanzstufe (5) eine abstimmbare Kapaziätsdiode (D3i) umfaßt und daß diese Reaktanzstufe (5) einerseits über eine Koppelspule (L31) mit dem Parallelschwingkreis (3) des ersten Oszillators (1) und andererseits über einen Koppelkondensator (C31) mit dem Parallelschwingkreis (4) des zweiten Oszillators (2) verbunden ist.

2. Schaltungsanordnung nach Anspruch 1, dadurch gekennzeichnet, daß die beiden Parallelschwingkreise (3, 4) jeweils eine Schwingkreisspule (L11, L21) und eine abstimmbare Kapazitätsdiode (D11, D21) aufweisen, daß der Hochpunkt der Schwingkreisspule (L11) des an den ersten Oszillator (1) angekoppelten Parallelschwingkreises (3) mit der Koppelspule (L31) verbunden ist und daß der Hochpunkt der Schwingkreisspule (L21) des an den zwei ten Oszillator (2) angekoppelten Parallelschwingkreises (4) mit dem Koppelkondensator (C31) verbunden ist.

3. Schaltungsanordnung nach einem der vorangehenden Ansprüche, dadurch gekennzeichnet, daß ein Kondensator (C32) mit der Kathode der Kapazitätsdiode (D31) der Reaktanzstufe (5) verbunden ist, und daß der Kathode der Kapazitätsdiode (D31) über einen Widerstand (R31) das AFC-Signal zugeführt wird.

4. Schaltungsanordnung nach Anspruch 3, dadurch gekennzeichnet, daß der Kondensator (C32) sowohl die Koppelspule (L31) als auch den Koppelkondensator (C31) mit der Kapazitätsdiode (D31) der Reaktanzstufe (5) verbindet.

5. Schaltungsanordnung nach einem der vorangehenden Ansprüche, dadurch gekennzeichnet, daß ein weiterer Kondensator (C33) der Kapazitätdiode (D31) der Reaktanzstufe (5) parallel geschaltet ist.

6. Schaltungsanordnung nach einem der Ansprüche 2 bis 5, dadurch gekennzeichnet, daß jeweils ein Kondensator (C11, C21) den Kapazitätsdioden (D11, D21) der Parallelschwingkreise (3, 4) in Reihe geschaltet ist, daß jeweils die Kathode der Kapazitätsdiode (D11, D21) der beiden Parallelschwingkreise (3, 4) mit dem jeweiligen Kondensator (C11, C21) verbunden ist, und daß den Kathoden der Kapazitätsdioden (D11 , D21) der beiden Parallelschwingkreise (3, 4) jeweils über einen Widerstand (R11, R21) die Abstimmspannung ($U_A$) zugeführt werden.

FIG.1

FIG. 2

FIG.3a

$$C_{D3} = C_{D31} + C_{33}$$

$$\frac{1}{C_{D1}} = \frac{1}{C_{D11}} + \frac{1}{C_{11}}$$

$$\frac{1}{C_{D2}} = \frac{1}{C_{D21}} + \frac{1}{C_{21}}$$

$$L_1 = L_{11} \parallel D_1$$

FIG.3b

FIG.3c

$L_2 = L_{31} + L_1$

FIG.3d

$C_x = L_2 \parallel D_3$

FIG.3e

$\dfrac{1}{C_y} = \dfrac{1}{C_x} + \dfrac{1}{C_{31}}$

$$\frac{1}{C_3} = \frac{1}{C_{D31}} + \frac{1}{C_{33}}$$

$$C_2 = L_{21} \| D_2$$

**FIG.4a**

$$\frac{1}{C_{D1}} = \frac{1}{C_{D11}} + \frac{1}{C_{11}}$$

$$\frac{1}{C_4} = \frac{1}{C_2 + C_{31}} + \frac{1}{C_3}$$

**FIG.4b**

$$L_3 = L_{31} + C_4$$

**FIG.4c**

**Europäisches Patentamt**

# EUROPÄISCHER RECHERCHENBERICHT

Nummer der Anmeldung

## EP 90 12 1185

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-3 611 154 (KUPFER)<br>* Figur; Spalte 3, Zeile 41 - Spalte 4, Zeile 27 *<br>- - - | 1-6 | H 03<br>J 7/08<br>H 03 B 5/12 |
| A | GB-A-2 215 929 (ALPS ELECTRIC CO., LTD)<br>* Figur 3; Seite 2, Zeile 16 - Seite 4, Zeile 22 *<br>- - - - - | 1-6 | |

|  |  |
|---|---|
| | RECHERCHIERTE SACHGEBIETE (Int. Cl.5) |
| | H 03 J<br>H 03 B |

Der vorliegende Recherchenbericht wurde für alle Patentansprüche erstellt

| Recherchenort | Abschlußdatum der Recherche | Prüfer |
|---|---|---|
| Den Haag | 27 März 91 | PEETERS M.M.G. |